# FASCICULE DE BREVET EUROPEEN

(11) **EP 3 690 458 B1**
(45) Date de publication et mention de la délivrance du brevet: **07.05.2025**
(21) Numéro de dépôt: 20154423.6
(22) Date de dépôt: 29.01.2020
(51) Int. Cl.: G01R 31/34

(54) **PROCEDE DE SUIVI DE TEMPS D'UTILISATION D'UN GROUPE ELECTROGENE, DISPOSITIF AUTONOME, PROCEDE DE SUIVI DE LA MAINTENANCE, ET SYSTEME CORRESPONDANTS**
ÜBERWACHUNGSVERFAHREN DER BENUTZUNGSZEIT EINES STROMGENERATORS, ENTSPRECHENDE AUTONOME VORRICHTUNG, ENTSPRECHENDES ÜBERWACHUNGSVERFAHREN DER WARTUNG UND SYSTEM
METHOD FOR TRACKING TIME OF USE OF A GENERATOR SET, CORRESPONDING STANDALONE DEVICE, MAINTENANCE MONITORING METHOD AND SYSTEM

(30) Priorité: 30.01.2019 FR 1900881
(43) Date de publication de la demande: 05.08.2020
(73) Titulaire: SDMO Industries, 29490 Guipavas (FR)
(72) Inventeur: BERGOT, Gilles, 29490 Guipavas (FR)
(74) Mandataire: Vidon Brevets & Stratégie

(56) Documents cités:
- CN-A- 108 919 123
- JP-A- S5 649 699
- RO-A2- 130 873
- US-A- 5 852 351
- US-A1- 2004 139 943
- US-A1- 2011 172 966
- US-A1- 2011 320 053
- US-A1- 2012 310 580
- US-A1- 2014 152 006
- US-A1- 2018 354 379

## Description

### 1. Domaine de l'invention

Le domaine de l'invention est celui du suivi de l'utilisation et de la maintenance de groupes électrogènes, et notamment des groupes électrogènes portables, destinés notamment à des mises en œuvre ponctuelles ou temporaires, sur tout type de site et de terrain.

La présente invention trouve donc en particulier des applications dans le domaine des groupes électrogènes portables, et plus généralement des systèmes mobiles comprenant des moyens de production d'électricité, tels que les groupes de soudage ou les mâts d'éclairage. Ces différents systèmes sont englobés par la suite dans le terme « groupe électrogène ».

### 2. Art antérieur

Les groupes électrogènes portables sont connus depuis de nombreuses années. Ils permettent à des utilisateurs d'avoir un dispositif de fourniture d'électricité d'appoint ou pour fournir de l'électricité sur tout type de site ou de terrain non alimenté de manière fixe en électricité (chantier, camping, port...). Ils peuvent être détenus par des particuliers ou des professionnels, ou mis en location par des sociétés de location de matériels.

Classiquement, un tel groupe électrogène comprend un châssis sur lequel sont montés notamment un moteur et un alternateur. Le moteur, typiquement un moteur thermique, entraîne en rotation l'alternateur, de façon à produire de l'électricité.

Les groupes électrogènes doivent faire l'objet d'une maintenance régulière, selon des durées de fonctionnement identifiées, déterminées par le fabricant, et par exemple mentionnées dans les notices. Il est utile, en conséquence, de mesurer les durées d'utilisation, ou de fonctionnement, d'un groupe électrogène, pour déterminer les moments où une maintenance est nécessaire.

Il est donc important que l'utilisateur, ou le responsable du parc, connaisse ces durées, et effectue ou fasse effectuer en temps utile les opérations de maintenance requises. Ceci est nécessaire pour garantir le bon fonctionnement du groupe électrogène et sa fiabilité.

Certains groupes, notamment les groupes de forte capacité, sont équipés de moyens de suivi intégrés, mesurant la présence d'un courant ou d'une tension électrique produite par le groupe, et des moyens de calcul des temps de fonctionnement correspondants et de gestion de la maintenance. En revanche, les groupes électrogènes portables ne présentent généralement pas de dispositif de ce type.

En effet, ces dispositifs ne sont pas aisément adaptables sur des groupes électrogènes portables, qui sont beaucoup moins coûteux, notamment pour des raisons de coût de revient.

Les utilisateurs doivent donc estimer par eux-mêmes les temps de fonctionnement, et donc les instants de maintenance. Cette absence de suivi autre que manuel est un inconvénient de tels groupes électrogènes portables, puisqu'ils peuvent en conséquence présenter un entretien ou une maintenance non régulière ou insuffisante, alors que les groupes électrogènes nécessitent, pour leur bon fonctionnement, une maintenance et un entretien réguliers de sorte que, notamment, leurs performances ne soient pas altérées.

Un mauvais suivi de l'entretien de ces groupes électrogènes portables, qui peut être également couplé à des défauts de manipulation (chocs, exposition à des températures extrêmes, ...) peut entraîner une détérioration accélérée du groupe électrogène et donc une durée de vie plus faible que prévue ce qui n'est pas satisfaisant.

En outre, en plus de la possibilité d'une détérioration du groupe électrogène, un entretien non régulier, c'est-à-dire non conforme aux recommandations constructeurs, peut engendrer des risques pour les utilisateurs.

Le document US5,852,351 divulgue un dispositif et un procédé de surveillance d'un moteur électrique.

Ainsi, il existe un besoin d'amélioration de ces groupes électrogènes portables.

### 3. Exposé de l'invention

Un objectif de la présente invention est donc de pallier au moins en partie ces inconvénients de l'art antérieur.

Cet objectif, ainsi que d'autres qui apparaitront dans la suite de la présente description, sont atteints à l'aide d'un procédé de suivi de temps d'utilisation d'un groupe électrogène, ledit procédé étant apte à fournir au moins une information caractéristique d'une durée de fonctionnement dudit groupe électrogène, tel que décrit dans la revendication 1. Selon l'invention, le procédé met en œuvre un dispositif autonome de mesure, et comprend en outre les étapes suivantes, mises en œuvre par ledit dispositif autonome, lorsqu'il est solidarisé à un châssis dudit groupe électrogène, et portant au moins deux capteurs :
- mesure d'une première grandeur physique, à l'aide d'un premier desdits capteurs ;
- mesure d'une deuxième grandeur physique, à l'aide d'un deuxième desdits capteurs ;
- analyse desdites première et deuxième grandeurs physiques, délivrant une information représentative d'un état de fonctionnement dudit groupe électrogène ;
- détermination d'une information représentative d'une durée globale de fonctionnement dudit groupe électrogène, par cumul de temps pendant lesquels ladite information représentative d'un état de fonctionnement est délivrée, et
- stockage de ladite information représentative d'une durée globale de fonctionnement dudit groupe électrogène.

Ainsi, l'invention propose une approche nouvelle et inventive permettant de résoudre au moins en partie les inconvénients de l'art antérieur.

Notamment, un tel procédé permet à un utilisateur de disposer d'un suivi de temps d'utilisation de son ou ses groupes électrogènes portables de façon simple et efficace, et donc d'effectuer ou de faire effectuer les opérations de maintenance requises.

Il est important de noter que les capteurs selon l'invention sont mis en œuvre dans un dispositif autonome, c'est-à-dire non connecté électriquement au groupe électrogène. Il serait en effet possible, comme proposé dans l'art antérieur, de mesurer la tension ou l'intensité du courant électrique produit par le groupe, mais l'invention a notamment pour objectif d'éviter toute connexion de ce type, de façon à disposer d'une solution simple et peu coûteuse. Il est donc prévu de mettre en œuvre un dispositif autonome, qui ne mesure pas l'énergie électrique produite, mais des phénomènes mesurables à distance, sans contact, et qui sont représentatifs d'un état de fonctionnement.

La prise en compte d'au moins deux grandeurs physiques distinctes permet de produire une information représentative d'un état de fonctionnement dudit groupe électrogène fiable, et en particulier résistante à une fausse détection par l'un ou l'autre des capteurs, due à un phénomène extérieur au groupe.

Ainsi, l'analyse n'est pas perturbée par l'environnement extérieur dans lequel est placé le groupe électrogène, environnement dans lequel une des deux mesures pourrait être perturbée et fausser l'analyse.

Par conséquent la détermination d'une information représentative d'une durée globale de fonctionnement du groupe électrogène est fiable.

Selon un aspect particulier d'au moins un mode de réalisation de l'invention, l'étape d'analyse desdites première et deuxième grandeurs physiques comprend les sous-étapes suivantes :
- traitement de la première grandeur mesurée ;
- comparaison de la première grandeur mesurée par rapport à un premier seuil de valeur prédéterminé ;
- traitement de la deuxième grandeur mesurée ;
- comparaison de la deuxième grandeur mesurée par rapport à un deuxième seuil de valeur prédéterminé, et
- délivrance de ladite information représentative d'un état de fonctionnement dudit groupe électrogène, en fonction de ladite sous-étape de comparaison de la première grandeur mesurée par rapport à un premier seuil de valeur prédéterminé et de ladite sous-étape comparaison de la deuxième grandeur mesurée par rapport à un deuxième seuil de valeur prédéterminé, si ladite première grandeur et ladite deuxième grandeur sont respectivement supérieures auxdits premier et deuxième seuils.

Ainsi, on ne considère pas que le groupe est en fonctionnement lorsqu'au moins une des mesures est inférieure au seuil associé. En d'autres termes, on considère que si seule une des mesures est supérieure au seuil, ceci signifie que le phénomène détecté, bien que réel, n'est pas produit par le groupe, et que celui-ci n'est pas en fonctionnement.

L'information représentative d'un état de fonctionnement dudit groupe électrogène est fiable, et tient compte des première et deuxième grandeurs mesurées.

Selon un mode de réalisation particulier, ladite première grandeur physique est représentative du fonctionnement d'un moteur dudit groupe électrogène, et en ce que ladite deuxième grandeur physique est représentative du fonctionnement d'un alternateur dudit groupe électrogène.

On détecte ainsi le fonctionnement de deux éléments majeurs du groupe électrogène, ce qui permet de fiabiliser la détection de fonctionnement. Le fonctionnement du moteur peut par exemple être détecté notamment en prenant en compte les vibrations qu'il génère, et le fonctionnement de l'alternateur peut par exemple être détecté à partir du champ électromagnétique qu'il produit.

Selon l'invention, le procédé comprend en outre une étape de transmission de ladite information caractéristique d'une durée globale de fonctionnement, depuis ledit dispositif autonome vers des moyens de traitement de données, lorsque ledit dispositif autonome est connecté auxdits moyens de traitement de données.

Dans ce cas, l'étape de transmission de ladite information caractéristique d'une durée globale de fonctionnement comprend également une sous étape de transmission d'au moins une information système sur ledit groupe électrogène, de sorte à identifier ledit groupe électrogène, ladite information système appartenant au groupe comprenant :
- un numéro de série du groupe électrogène ;
- des données de localisation dudit groupe électrogène, ou
- un modèle de groupe électrogène.

Ceci permet de disposer d'une information complémentaire permettant par exemple d'optimiser la maintenance et le suivi, notamment dans le cas d'un suivi d'une pluralité de groupes électrogènes portables.

Selon une caractéristique particulière d'au moins un mode de réalisation de l'invention, le procédé comprend une étape préliminaire d'appairage dudit dispositif autonome auxdits moyens de traitement de données.

Cela permet ainsi d'éviter qu'un tiers puisse se connecter et recueillir des données, de manière intentionnelle ou non.

L'invention concerne également un dispositif autonome selon la revendication 5 mettant en œuvre un procédé selon l'un des modes de réalisation précités.

L'invention concerne en outre un procédé de suivi de la maintenance d'un groupe électrogène, dans un dispositif communicant ou un serveur, tel que décrit dans la revendication 6, et comprenant les étapes suivantes :
- réception d'une information caractéristique d'une durée globale de fonctionnement par un dispositif autonome selon la revendication 5, ladite information étant obtenue par la mise en œuvre d'un procédé selon les revendications 1 à 4 ;
- traitement de ladite information caractéristique d'une durée globale de fonctionnement, délivrant au moins une information relative à la maintenance dudit groupe électrogène, en fonction de la durée de fonctionnement de ce dernier.

Ainsi, c'est ce dispositif communicant (téléphone, tablette, ordinateur...) ou ce serveur qui analyse les durées de fonctionnement, et détermine si une maintenance doit être effectuée ou non. Le dispositif autonome peut « se contenter » de compiler une durée de fonctionnement, et de la fournir à un élément distant qui l'exploite.

Un tel procédé permet ainsi d'effectuer efficacement et simplement un suivi de la durée globale de fonctionnement d'un groupe électrogène et des opérations de maintenance à effectuer ou faire effectuer.

Selon une caractéristique d'au moins un mode de réalisation de l'invention, ladite au moins une information relative à la maintenance appartient au groupe comprenant :
- un nombre d'heures total d'utilisation du groupe électrogène ;
- un nombre d'heures en continu d'utilisation du groupe électrogène ;
- une date de première utilisation du groupe électrogène ;
- une date de dernière utilisation du groupe électrogène ;
- une autonomie du groupe électrogène ;
- une nécessité de démarrer le groupe électrogène ;
- une nécessité d'arrêter le groupe électrogène ;
- un conseil d'utilisation du groupe électrogène, ou
- le besoin d'effectuer une maintenance dudit groupe électrogène.

Selon un autre aspect d'au moins un mode de réalisation de l'invention, le procédé comprend en outre une étape de transmission d'au moins une donnée de maintenance depuis les moyens de traitement vers ledit dispositif autonome.

De ce fait, cela peut par exemple permettre d'effectuer des mises à jour des opérations effectuées sur le groupe électrogène ou de données diverses fournies par l'utilisateur qui pourraient s'avérer importantes pour le dispositif autonome.

Dans ce cas, la au moins une donnée de maintenance transmise depuis lesdits moyens de traitement vers ledit dispositif autonome peut appartenir au groupe comprenant :
- une mise à jour d'un carnet d'entretien du groupe électrogène ;
- une date de maintenance réalisée ;
- un numéro de série ;
- un plan de maintenance à suivre ;
- une donnée d'utilisateur ;
- une commande de réinitialisation de ladite information représentative d'une durée globale de fonctionnement.

Selon une caractéristique d'au moins un mode de réalisation de l'invention, lesdits moyens de traitement comprennent un terminal externe, et en ce que ledit procédé comprend au moins une étape parmi :
- une étape d'affichage d'au moins une donnée parmi ladite au moins une donnée de maintenance, ladite information système sur ledit groupe électrogène, ladite au moins une information caractéristique d'une durée globale de fonctionnement, et
- une étape de réception d'instructions d'un utilisateur interagissant avec ledit terminal externe.

Ainsi, un utilisateur peut disposer d'un visuel sur les données concernant son ou ses groupes électrogènes, et également d'interagir notamment dans le suivi de la maintenance du groupe électrogène.

En d'autres termes, cela permet de communiquer des informations sur un groupe électrogène à un utilisateur, et permet également à l'utilisateur de communiquer des informations.

L'invention concerne en outre un produit programme d'ordinateur téléchargeable depuis un réseau de communication et/ou stocké sur un support lisible par microprocesseur et/ou exécutable par un microprocesseur, caractérisé en ce qu'il comprend des instructions de code de programme pour l'exécution d'un procédé de maintenance d'un groupe électrogène selon l'un des modes de réalisation précités, lorsqu'il est exécuté sur un ordinateur.

L'invention concerne encore un médium de stockage lisible par ordinateur et non transitoire, stockant un programme d'ordinateur comprenant un jeu d'instructions exécutables par un ordinateur ou un processeur pour mettre en œuvre le procédé selon l'un des modes de réalisation précités.

L'invention concerne enfin un système comprenant :
- un groupe électrogène ;
- un dispositif autonome de suivi de temps d'utilisation d'un groupe électrogène, fixé audit groupe électrogène, selon l'invention, et
- des moyens de traitement de données, aptes à mettre en œuvre un procédé de suivi de la maintenance d'un groupe électrogène selon l'un des modes de réalisation précités.

Selon un mode de réalisation de l'invention, le système comprend en outre un serveur relié auxdits moyens de traitement de données de sorte à stocker au moins en partie des informations relatives à la maintenance dudit groupe électrogène.

### 4. Liste des figures

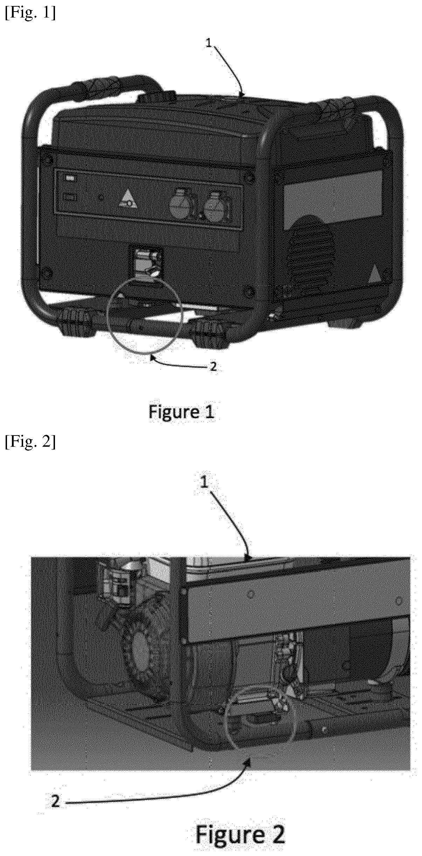

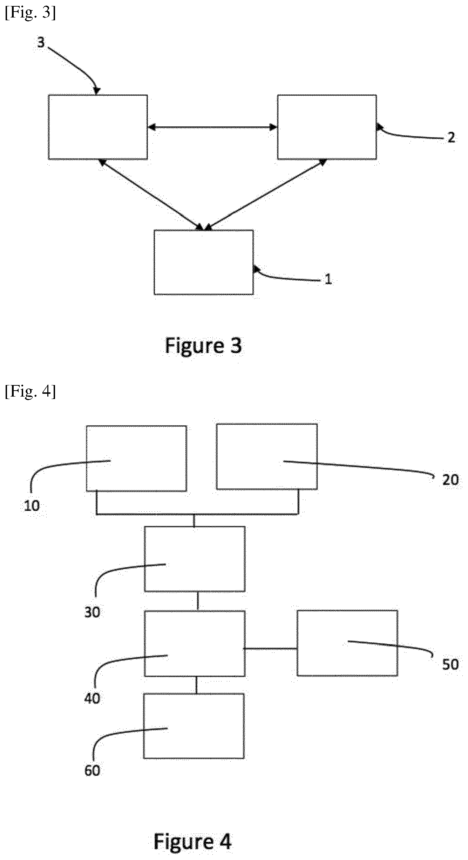

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
[fig.1]
   est une vue en perspective d'un groupe électrogène comprenant un dispositif autonome mettant en œuvre un procédé de suivi du temps d'utilisation du groupe électrogène selon un mode de réalisation de l'invention ;
[fig.2]
   est une vue en perspective d'une partie d'un groupe électrogène, sans cache latéral, comprenant un dispositif autonome de suivi du temps d'utilisation mettant en œuvre un procédé de suivi du temps d'utilisation du groupe électrogène selon le mode de réalisation de la [Fig. 1] ;
[fig.3]
   est un schéma illustrant un système selon un mode de réalisation de l'invention ;
[fig.4]
   est un schéma illustrant un procédé de suivi de temps d'utilisation selon un mode de réalisation de l'invention ;
[fig.5]
   est un schéma illustrant en détail l'étape d'analyse du procédé de suivi selon le mode de réalisation de la [Fig. 4] ;
[fig.6]
   est un schéma illustrant un procédé de suivi de la maintenance d'un groupe électrogène selon un mode de réalisation de l'invention ;
[fig.7]
   est un schéma illustrant en détail l'étape de détermination du procédé de suivi selon le mode de réalisation de la [Fig. 4] , et
[fig.8]
   est un logigramme présentant différents modes de réalisation du comptage de la durée de fonctionnement du groupe électrogène.

### 5. Description d'un mode de réalisation

On illustre par la suite un premier mode de réalisation de l'invention, traité à titre de simple exemple illustratif, et non limitatif, avec l'appui des figures 1 à 8.

Comme illustré sur la figure 1, le groupe électrogène 1 comprend un châssis, autrement appelé socle, formant la structure rigide du groupe électrogène, ainsi qu'un capot de protection et un cache latéral protégeant les différents composants.

Sur le châssis et sous le capot sont montés les différents éléments nécessaires à la production d'électricité, et notamment un moteur et un alternateur.

Comme illustré sur les figures 1 et 2, le groupe électrogène porte en outre un dispositif autonome 2 de suivi de temps d'utilisation du groupe électrogène, qui est solidarisé avec le groupe électrogène.

Le terme « autonome » signifie ici que le dispositif n'est pas alimenté électriquement par le groupe électrogène, ni connecté électriquement à celui-ci, par exemple pour relever un courant ou une tension. Cette approche « intrusive » est certes une possibilité pour avoir connaissance du fonctionnement, mais sa mise en œuvre peut être relativement complexe et coûteuse, et peu adaptée aux groupes électrogènes portables.

Ce dispositif autonome 2 est par exemple placé à proximité du moteur et de l'alternateur de sorte à faciliter la captation de signaux émis par ces éléments. Plus particulièrement, une telle proximité permet d'avoir un suivi qui soit relativement précis et fiable, et pour lequel l'environnement extérieur aura un impact réduit sur les données recueillies.

Le dispositif autonome de suivi du temps d'utilisation pour groupe électrogène 9 est apte à fournir au moins une information caractéristique d'une durée de fonctionnement de ce groupe électrogène.

Pour ce faire, le dispositif autonome 2 porte au moins deux capteurs permettant de mesurer au moins deux grandeurs physiques.

Dans le mode de réalisation illustré, les deux grandeurs physiques mesurées sont la présence d'un champ magnétique généré par l'alternateur du groupe électrogène et la présence de vibrations générées par le moteur du groupe.

Plus particulièrement, un premier capteur est un capteur magnétique apte à relever la présence d'un champ magnétique généré par l'alternateur du groupe électrogène.

La première grandeur physique mesurée par ce premier capteur peut donc être représentative de la rotation de l'alternateur du groupe électrogène, ce qui est un paramètre relativement parlant du fait que la différence est importante entre le champ magnétique généré par l'alternateur lorsque celui-ci est en fonctionnement ou non.

En effet, la différence de valeur relevée du champ magnétique généré par l'alternateur est très importante si celui-ci est éteint ou en fonctionnement.

Le fait que le dispositif autonome 2 soit placé à proximité de l'alternateur, comme illustré sur les figures 1 et 2, permet également d'obtenir des relevés fiables de cette première grandeur physique.

Un deuxième capteur est un capteur de vibration apte à capter des vibrations générées par le moteur du groupe électrogène 1. Un tel capteur permet de détecter les vibrations du moteur, lorsqu'il est en fonctionnement.

Ainsi, ce dispositif autonome 2 met en œuvre un procédé de suivi de temps d'utilisation du groupe électrogène 1, ce procédé étant apte à fournir au moins une information caractéristique d'une durée de fonctionnement du groupe électrogène 1.

Selon l'invention, le procédé, illustré en figure 4, comprend les étapes suivantes :
- une étape 10 de mesure de la première grandeur physique, ici le champ électromagnétique généré par l'alternateur, à l'aide du premier capteur ;
- une étape 20 de mesure de la deuxième grandeur physique, ici les vibrations émises par le moteur, à l'aide du deuxième capteur ;
- une étape 30 d'analyse des première et deuxième grandeurs physiques, délivrant une information représentative d'un état de fonctionnement du groupe électrogène 1 ;
- une étape 40 de détermination d'une information représentative d'une durée globale de fonctionnement du groupe électrogène 1, par cumul de temps pendant lesquels l'information représentative d'un état de fonctionnement est délivrée, et
- une étape 50 de stockage de l'information représentative d'une durée globale de fonctionnement du groupe électrogène 1.

Une fois les première et deuxième grandeurs mesurées, l'étape 30 d'analyse permet de délivrer une information représentative d'un état de fonctionnement du groupe électrogène 1, c'est-à-dire notamment de définir si le groupe électrogène 1 est en marche ou à l'arrêt au moment des mesures.

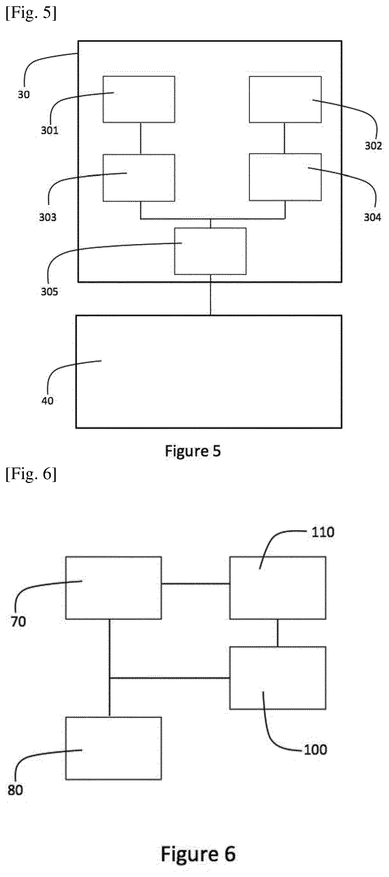

Pour ce faire, l'étape 30 d'analyse des première et deuxième grandeurs physiques, comprend par exemple, comme illustré en figure 5, les sous-étapes suivantes :
- obtention 301 de la première grandeur mesurée, et le cas échéant prétraitement (filtrage, lissage...) ;
- comparaison 303 de la première grandeur mesurée par rapport à un premier seuil de valeur prédéterminé, enregistré dans le dispositif autonome ;
- traitement 302 de la deuxième grandeur mesurée, et le cas échéant prétraitement (filtrage, lissage...) ;
- comparaison 304 de la deuxième grandeur mesurée par rapport à un deuxième seuil de valeur prédéterminé, enregistré dans le dispositif autonome, et
- délivrance 305 de l'information représentative d'un état de fonctionnement du groupe électrogène, en fonction de la sous-étape de comparaison 303 de la première grandeur mesurée par rapport à un premier seuil de valeur prédéterminé et de la sous-étape comparaison 304 de la deuxième grandeur mesurée par rapport à un deuxième seuil de valeur prédéterminé, si la première grandeur et la deuxième grandeur sont respectivement supérieures aux premier et deuxième seuils.

Ainsi, si la première grandeur est supérieure au premier seuil de valeur prédéterminé, et si la deuxième grandeur est supérieure au deuxième seuil de valeur prédéterminé, dans ce cas le groupe électrogène est considéré comme étant en marche et l'information représentative d'un état de fonctionnement du groupe électrogène est délivrée.

En d'autres termes, le groupe électrogène est considéré en fonctionnement lorsque les deux capteurs mesurent des grandeurs physiques des paramètres indiquant un fonctionnement potentiel, c'est-à-dire lorsque le moteur et l'alternateur du groupe électrogène sont en marche.

Dans ce mode de réalisation, le premier seuil correspond à 5µT.

Plus généralement, le premier seuil peut être compris entre 25 µT et 450µT.

Par ailleurs, et également dans ce mode de réalisation, le premier seuil correspond à 10 Hz.

Plus généralement, le premier seuil peut être compris entre 20 Hz et 200 Hz.

Le fait de disposer d'un premier capteur et d'un deuxième capteur permet de délivrer une information caractéristique d'un état de fonctionnement qui est fiable, par exemple sans perturbation de l'environnement extérieur dans lequel est placé le groupe électrogène.

En effet, dans l'hypothèse où le groupe électrogène est placé dans un environnement présentant un fort champ magnétique, les mesures de la première grandeur physique faites par le premier capteur peuvent être perturbées. Toutefois, en recoupant avec les mesures de la deuxième grandeur physique faites par le deuxième capteur de vibration, le relevé d'un champ magnétique lorsque le groupe électrogène n'est pas en fonctionnement n'est pas identifié comme un fonctionnement du groupe électrogène car le deuxième capteur ne capte pas de vibration au niveau du moteur.

Il en est de même dans l'hypothèse ou des vibrations se produisent au niveau du groupe électrogène, par exemple lorsque celui-ci est en cours de transport. Dans ce cas, les mesures de la deuxième grandeur physique faites par le deuxième capteur peuvent être perturbées du fait des vibrations, dues par exemple aux irrégularités de la route pendant le transport du groupe électrogène. Toutefois, en recoupant avec les mesures de la première grandeur physique faites par le premier capteur de champ magnétique, la détection de vibrations lorsque le groupe électrogène n'est pas en fonctionnement n'est pas identifiée comme un fonctionnement du groupe électrogène car le premier capteur ne relève alors pas de champ magnétique au niveau de l'alternateur.

Ainsi, à partir de l'analyse de grandeurs physiques connexes, ici le champ magnétique émis par l'alternateur et les vibrations émises par le moteur, le procédé délivre alors, lors de l'étape d'analyse 30 des première et deuxième grandeurs physiques, une information caractéristique d'un état de fonctionnement du groupe électrogène qui est fiable.

Il est à noter que, selon d'autres modes de réalisation, on pourrait prévoir que les première grandeur physique et deuxième grandeur physique soient d'autres types, et donc que le premier capteur et le deuxième capteur soient d'autres types. Il est également possible de prendre en compte plus de deux types de capteurs.

Par exemple, on pourrait mettre en œuvre un capteur de température, par exemple de température du moteur.

On pourrait en outre prévoir un capteur de tension aux bornes d'éléments du groupe électrogène.

On pourrait également prévoir un capteur acoustique, par exemple pour évaluer le volume sonore (et/ou d'autres caractéristiques sonores) générés par le moteur et/ou par la rotation de l'alternateur.

On pourrait encore prévoir un capteur de pression d'huile, un capteur de vitesse de rotation de l'alternateur, ou un capteur de flux d'air.

Par ailleurs, le traitement présenté ici à titre d'exemple, mettant en œuvre une comparaison des signaux mesurés à des seuils prédéterminés, peut être remplacé par un autre traitement, analysant de façon plus précise les deux signaux, par exemple sur la base de filtrages ou de transformées mathématiques, de façon à rendre la décision « groupe en fonctionnement » la plus précise possible.

Les seuils peuvent être prédéterminés, de façon adaptée à chaque type de groupes électrogènes, ou calibrés de façon précise pour chaque groupe, au moment de sa fabrication, ou encore mis à jour périodiquement, par exemple lors de maintenances.

Comme illustré sur les figures 4 et 5, et comme évoqué ci-dessus, le procédé comprend ensuite une étape 40 de détermination d'une information représentative d'une durée globale de fonctionnement du groupe électrogène 1, par cumul de temps pendant lesquels l'information représentative d'un état de fonctionnement est délivrée.

En d'autres termes, si l'information caractéristique d'un état de fonctionnement du groupe électrogène est délivrée, l'information représentative d'une durée globale de fonctionnement du groupe électrogène est incrémentée d'une unité temporelle donnée.

En revanche, si l'information caractéristique d'un état de fonctionnement du groupe électrogène n'est pas délivrée, l'information représentative d'une durée globale de fonctionnement du groupe électrogène n'est pas incrémentée d'une unité temporelle donnée et reste donc invariable.

Par exemple, si cette information représentative d'une durée globale de fonctionnement du groupe électrogène est nulle, correspondant à un groupe électrogène à l'arrêt, elle reste nulle.

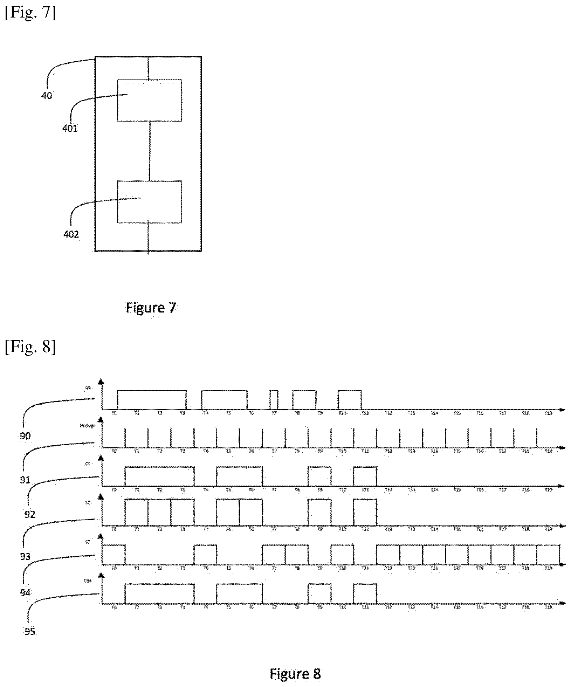

Pour expliciter plus encore la détermination de l'information représentative d'une durée globale de fonctionnement, on présente maintenant, à l'appui des figures 7 et 8, des exemples de réalisation particuliers de l'étape 40 de détermination.

Comme illustré en figure 7, dans ce mode de réalisation, l'étape 40 de détermination comprend les sous-étapes suivantes :
- sous étape 401 de détermination d'une durée courante de fonctionnement ;
- sous étape 402 de détermination d'une durée globale de fonctionnement, en fonction de ladite durée courante.

La figure 8 illustre trois différentes modes de comptage de la durée courante de fonctionnement du groupe électrogène. Sur cette figure 8, le graphique 90 illustre les périodes où le groupe électrogène est effectivement en fonctionnement.

Le graphique 91 illustre, par des impulsions, les instants où l'étape d'analyse des première et deuxième grandeurs physiques est effectuée.

Trois différents modes de comptages de la durée courante de fonctionnement du groupe électrogène sont alors illustrés, et par conséquent de comptage de la durée globale de fonctionnement du groupe électrogène.

Dans le mode de comptage du graphique 92, le compteur considère un fonctionnement du groupe électrogène dès lors que l'analyse délivre une information représentative de l'état de fonctionnement du groupe électrogène et cesse de considérer ce fonctionnement que lorsque l'étape d'analyse ne délivre plus cette information représentative.

Dans le mode de comptage du graphique 93, le compteur considère un fonctionnement du groupe électrogène dès lors que l'analyse délivre une information représentative de l'état de fonctionnement, et considère que le groupe est en fonctionnement pendant l'intervalle entre deux étapes d'analyses successives.

Le mode de comptage du graphique 94 est opposé au mode de comptage du graphique 92. Pour avoir la durée courante de fonctionnement, il est alors nécessaire d'obtenir l'inverse, comme illustré au graphique 95.

Lors de l'étape 50 de stockage de l'information représentative d'une durée globale de fonctionnement du groupe électrogène 1, cette information est stockée dans une mémoire du dispositif autonome.

Dans le mode de réalisation du procédé de suivi de temps d'utilisation du groupe électrogène 1 illustré en figure 4, celui-ci comprend en outre une étape de transmission 60 de l'information caractéristique d'une durée globale de fonctionnement, depuis le dispositif autonome 2 vers des moyens 3 de traitement de données, lorsque le dispositif autonome 2 est connecté aux moyens 3 de traitement de données.

De sorte à connecter le dispositif autonome 2 aux moyens 3 de traitement de données, le procédé comprend, dans ce mode de réalisation, une étape préliminaire d'appairage du dispositif autonome 2 aux moyens 3 de traitement de données.

Une telle étape permet d'avoir une authentification réciproque des moyens de traitement et du dispositif autonome ce qui sécurise les données. Ainsi, un tiers ne peut pas accéder aux données sans avoir effectuer un appairage préalable.

Cette étape de transmission de l'information peut, par exemple, être basée sur une technologie connue sous le nom Bluetooth « Low Energy ».

On pourrait également une étape de transmission basée sur une technologie NFC, Zigbee, Bluetooth, Zwave, WiFi, LoRa, Sigfox, voire même les réseaux cellulaires mobiles ou les réseaux radio bas-débits. Notamment, le dispositif autonome et les moyens de traitement peuvent communiquer via des protocoles destinés à « l'internet des objets ».

Selon un mode de réalisation, l'étape de transmission de l'information caractéristique d'une durée globale de fonctionnement, depuis le dispositif autonome vers les moyens de traitement de données, peut se faire automatiquement dès que les moyens de traitement de données et le dispositif autonome peuvent être connectés l'un à l'autre de manière automatique. En d'autres termes, l'échange de données peut se faire sur sollicitation de l'utilisateur, qui lance une application dédiée et/ou une commande d'interrogation de cette application, ou de façon automatique. Dans ce dernier cas, l'application peut tourner en permanence, en tâche de fond, pour entrer en contact avec le dispositif autonome dès que celui-ci se trouve à proximité. En variante, le dispositif autonome peut lui-même entrer en communication avec un dispositif adapté ou un serveur, par exemple lorsqu'il détecte un réseau disponible, à l'aide d'un protocole adapté à « l'internet des objets ».

Cette étape de transmission 60 de l'information caractéristique d'une durée globale de fonctionnement comprend également, dans ce mode de réalisation une sous étape de transmission d'au moins une information système sur le groupe électrogène 1, de sorte à identifier le groupe électrogène en question.

Une telle sous-étape est par exemple intéressante dans le cas d'un parc de groupes électrogènes, de sorte à identifier à quel groupe électrogène correspond l'information caractéristique d'une durée globale de fonctionnement.

Une telle information système peut par exemple être :
- un numéro de série du groupe électrogène ;
- des données de localisation du groupe électrogène, ou
- un modèle de groupe électrogène.

De ce fait, on peut prévoir que le dispositif autonome présente des moyens de géolocalisation. Ceci permet au gestionnaire de savoir précisément où est chaque groupe électrogène, et par exemple de contrôler qu'il est bien dans un lieu prévu. C'est également une aide possible, en cas de perte ou de vol du groupe électrogène.

On peut également prévoir un mode de réalisation dans lequel l'étape de transmission 60 de l'information caractéristique d'une durée globale de fonctionnement comprend également une sous étape de transmission d'autres données telles que :
- la détection de chocs sur le groupe électrogène ;
- un profil de puissance débitée par le groupe électrogène ;
- une surcharge du groupe électrogène, ou
- une sous-charge du groupe électrogène.

Selon un aspect de l'invention, illustré notamment par la figure 3, le groupe électrogène 1, le dispositif autonome 2 de suivi de temps d'utilisation, et les moyens de traitement de données forment un système permettant d'avoir un suivi du temps d'utilisation du groupe électrogène 1 mais également un suivi de la maintenance de ce groupe électrogène 1.

Ce suivi de la maintenance du groupe électrogène 1 est plus particulièrement effectué en lien avec les moyens de traitement de données qui sont aptes à mettre en œuvre un procédé de suivi de la maintenance du groupe électrogène.

Ainsi, dans ce procédé de suivi de la maintenance du groupe électrogène 1, illustré notamment en figure 6, lorsque les moyens de traitement reçoivent une information caractéristique d'une durée globale de fonctionnement par le dispositif autonome 2, le procédé comprend une étape 70 de traitement de l'information caractéristique d'une durée globale de fonctionnement, par les moyens 3 de traitement de données, de sorte à délivrer au moins une information relative à la maintenance du groupe électrogène 1, en fonction de la durée de fonctionnement de ce dernier.

En d'autres termes, les moyens 3 de traitement analysent l'information caractéristique d'une durée globale de fonctionnement transmise par le dispositif autonome 2 afin de délivrer au moins une information relative à la maintenance du groupe électrogène 1.

Une telle information relative à la maintenance peut-être, selon ce mode de réalisation :
- un nombre d'heures total d'utilisation du groupe électrogène ;
- un nombre d'heures en continu d'utilisation du groupe électrogène ;
- une date de première utilisation du groupe électrogène ;
- une date de dernière utilisation du groupe électrogène ;
- une autonomie du groupe électrogène ;
- une nécessité de démarrer le groupe électrogène ;
- une nécessité d'arrêter le groupe électrogène ;
- un conseil d'utilisation du groupe électrogène, ou
- le besoin d'effectuer une maintenance dudit groupe électrogène.

Cette information relative à la maintenance peut, par exemple être communiquée à un utilisateur par le biais d'un terminal externe compris par les moyens 3 de traitement.

Ce terminal externe peut par exemple être un smartphone ou une tablette, permettant d'afficher l'information relative à la maintenance, mais permettant également à un utilisateur de donner des instructions.

Plus particulièrement, dans ce mode de réalisation, le procédé comprend au moins une étape parmi :
- une étape d'affichage 110 d'au moins une donnée de maintenance, au moins une information relative à la maintenance, l'information système sur le groupe électrogène 1, la au moins une information caractéristique d'une durée globale de fonctionnement, et
- une étape de réception d'instructions 100 d'un utilisateur interagissant avec le terminal externe.

Il est à noter que le système peut en outre comprendre un serveur relié aux moyens 3 de traitement de données de sorte à stocker au moins en partie des informations relatives à la maintenance du groupe électrogène.

On peut également prévoir que, dans un mode de réalisation, le serveur stocke également au moins une donnée de maintenance, au moins une information relative à la maintenance, l'information système sur le groupe électrogène 1, ou la au moins une information caractéristique d'une durée globale de fonctionnement.

Dans le mode de réalisation illustré notamment en figure 6, suite à l'étape d'affichage 110, et à l'étape de réception d'instructions 100 de l'utilisateur interagissant avec le terminal externe, en vue de rentrer des données de maintenance, le procédé comprend en outre une étape de transmission 80 d'au moins une donnée de maintenance depuis les moyens 3 de traitement vers le dispositif autonome 2.

Une telle donnée de maintenance transmise depuis les moyens 3 de traitement vers le dispositif autonome 2 appartient au groupe comprenant :
- une mise à jour d'un carnet d'entretien du groupe électrogène ;
- une date de maintenance réalisée ;
- un numéro de série ;
- un plan de maintenance à suivre ;
- une donnée d'utilisateur, telle qu'une coordonnée, et
- une commande de réinitialisation de ladite information représentative d'une durée globale de fonctionnement.

En d'autres termes, suite à l'étape d'affichage, l'utilisateur peut prendre des mesures, en fonction de la donnée affichée, et ensuite interagir avec le terminal externe lors de l'étape de réception d'instructions 100.

Par exemple, dans le cas de l'affichage d'un besoin d'effectuer une maintenance dudit groupe électrogène, l'utilisateur effectue la maintenance du groupe électrogène puis, lorsque cette maintenance est effective, il entre une date de maintenance réalisée, cette date étant transmise lors de l'étape de transmission 80 d'au moins une donnée de maintenance depuis les moyens 3 de traitement vers le dispositif autonome 2.

Une telle étape permet de mettre à jour le dispositif autonome 2 au même titre que les moyens 3 de traitement, de sorte à ce que le suivi de la maintenance du groupe électrogène soit optimal.

L'invention concerne également un produit programme d'ordinateur téléchargeable depuis un réseau de communication et/ou stocké sur un support lisible par microprocesseur et/ou exécutable par un microprocesseur, comprenant des instructions de code de programme pour l'exécution d'un procédé de maintenance d'un groupe électrogène selon l'un des modes de réalisation précités, lorsqu'il est exécuté sur un ordinateur.

L'invention concerne également un médium de stockage lisible par ordinateur et non transitoire, stockant un programme d'ordinateur comprenant un jeu d'instructions exécutables par un ordinateur ou un processeur pour mettre en œuvre le procédé de maintenance d'un groupe électrogène selon l'un des modes de réalisation précités.

Plus particulièrement, le médium de stockage peut être inclus dans le serveur relié aux moyens de traitement de données.

## Revendications

1. Procédé de suivi de temps d'utilisation d'un groupe électrogène (1), ledit procédé étant apte à fournir au moins une information caractéristique d'une durée de fonctionnement dudit groupe électrogène, ledit procédé mettant en œuvre un dispositif autonome (2) de mesure portant au moins deux capteurs, ledit procédé comprenant les étapes suivantes, mises en œuvre par ledit dispositif autonome, lorsqu'il est solidarisé à un châssis dudit groupe électrogène:
- mesure (10) d'une première grandeur physique, à l'aide d'un premier desdits capteurs ;
- mesure (20) d'une deuxième grandeur physique, à l'aide d'un deuxième desdits capteurs ;
- analyse (30) desdites première et deuxième grandeurs physiques, délivrant une information représentative d'un état de fonctionnement dudit groupe électrogène ;
- détermination (40) d'une information représentative d'une durée globale de fonctionnement dudit groupe électrogène, par cumul de temps pendant lesquels ladite information représentative d'un état de fonctionnement est délivrée,
- stockage (50) de ladite information représentative d'une durée globale de fonctionnement dudit groupe électrogène, et
- transmission (60) de ladite information caractéristique d'une durée globale de fonctionnement, depuis ledit dispositif autonome vers des moyens de traitement de données, lorsque ledit dispositif autonome est connecté auxdits moyens de traitement de données,
**caractérisé en ce que** ledit procédé comprend en outre une étape d'obtention de données de localisation dudit groupe électrogène et **en ce que** ladite étape de transmission (60) comprend une sous-étape de transmission d'au moins une desdites données de localisation dudit groupe électrogène, de sorte à identifier ledit groupe électrogène.

2. Procédé de suivi de temps d'utilisation selon la revendication 1, **caractérisé en ce que** l'étape d'analyse (30) desdites première et deuxième grandeurs physiques comprend les sous-étapes suivantes :
- traitement (301) de la première grandeur mesurée ;
- comparaison (303) de la première grandeur mesurée par rapport à un premier seuil de valeur prédéterminé ;
- traitement (302) de la deuxième grandeur mesurée ;
- comparaison (304) de la deuxième grandeur mesurée par rapport à un deuxième seuil de valeur prédéterminé, et
- délivrance (305) de ladite information représentative d'un état de fonctionnement dudit groupe électrogène, en fonction de ladite sous-étape de comparaison (303) de la première grandeur mesurée par rapport à un premier seuil de valeur prédéterminé et de ladite sous-étape comparaison (304) de la deuxième grandeur mesurée par rapport à un deuxième seuil de valeur prédéterminé, si ladite première grandeur et ladite deuxième grandeur sont respectivement supérieures auxdits premier et deuxième seuils.

3. Procédé de suivi de temps d'utilisation selon l'une des revendications 1 ou 2, **caractérisé en ce que** ladite première grandeur physique est représentative du fonctionnement d'un moteur dudit groupe électrogène, et **en ce que** ladite deuxième grandeur physique est représentative du fonctionnement d'un alternateur dudit groupe électrogène.

4. Procédé de suivi de temps d'utilisation selon l'une quelconque des revendications 1 ou 2, **caractérisé en ce qu'**il comprend une étape préliminaire d'appairage dudit dispositif autonome auxdits moyens de traitement de données.

5. Dispositif autonome **caractérisé en ce qu'**il est adapté pour la mise en œuvre d'un procédé selon l'une des revendications 1 à 4.

6. Procédé de suivi de la maintenance d'un groupe électrogène, dans un dispositif communicant ou un serveur, **caractérisé en ce qu'**il comprend les étapes suivantes :
- réception d'une information caractéristique d'une durée globale de fonctionnement par un dispositif autonome selon la revendication 5, ladite information étant obtenue par ledit dispositif avec la mise en œuvre d'un procédé selon l'une des revendications 1 à 4 ;
- traitement (70) de ladite information caractéristique d'une durée globale de fonctionnement, délivrant au moins une information relative à la maintenance dudit groupe électrogène, en fonction de la durée de fonctionnement de ce dernier.

7. Procédé de suivi de la maintenance d'un groupe électrogène selon la revendication 6, **caractérisé en ce que** ladite au moins une information relative à la maintenance appartient au groupe comprenant :
- un nombre d'heures total d'utilisation du groupe électrogène ;
- un nombre d'heures en continu d'utilisation du groupe électrogène ;
- une date de première utilisation du groupe électrogène ;
- une date de dernière utilisation du groupe électrogène ;
- une autonomie du groupe électrogène ;
- une nécessité de démarrer le groupe électrogène ;
- une nécessité d'arrêter le groupe électrogène ;
- un conseil d'utilisation du groupe électrogène, ou
- le besoin d'effectuer une maintenance dudit groupe électrogène.

8. Procédé de suivi de la maintenance d'un groupe électrogène selon l'une des revendications 6 ou 7, **caractérisé en ce qu'**il comprend en outre une étape de transmission (80) d'au moins une donnée de maintenance depuis les moyens de traitement vers ledit dispositif autonome.

9. Procédé de suivi de la maintenance d'un groupe électrogène selon la revendication 8, **caractérisé en ce que** ladite au moins une donnée de maintenance transmise depuis lesdits moyens de traitement vers ledit dispositif autonome appartient au groupe comprenant :
- une mise à jour d'un carnet d'entretien du groupe électrogène ;
- une date de maintenance réalisée ;
- un numéro de série ;
- un plan de maintenance à suivre ;
- une donnée d'utilisateur ;
- une commande de réinitialisation de ladite information représentative d'une durée globale de fonctionnement.

10. Procédé de suivi de la maintenance d'un groupe électrogène selon l'une des revendications 9 ou 10, **caractérisé en ce que** lesdits moyens de traitement comprennent un terminal externe, et **en ce que** ledit procédé comprend au moins une étape parmi :
- une étape d'affichage (90) d'au moins une donnée parmi ladite au moins une donnée de maintenance, ladite information système sur ledit groupe électrogène, ladite au moins une information caractéristique d'une durée globale de fonctionnement, et
- une étape de réception d'instructions (100) d'un utilisateur interagissant avec ledit terminal externe.

11. Produit programme d'ordinateur téléchargeable depuis un réseau de communication et/ou stocké sur un support lisible par microprocesseur et/ou exécutable par un microprocesseur, **caractérisé en ce qu'**il comprend des instructions de code de programme pour l'exécution d'un procédé de maintenance d'un groupe électrogène selon l'une des revendications 6 à 10, lorsqu'il est exécuté sur un ordinateur.

12. Médium de stockage lisible par ordinateur et non transitoire, stockant un programme d'ordinateur comprenant un jeu d'instructions exécutables par un ordinateur ou un processeur pour mettre en œuvre le procédé selon l'une des revendications 6 à 10.

13. Système comprenant :
- un groupe électrogène (1) ;
- un dispositif autonome (2) de suivi de temps d'utilisation d'un groupe électrogène, fixé audit groupe électrogène, selon la revendication 5, et
- des moyens (3) de traitement de données, aptes à mettre en œuvre un procédé de suivi de la maintenance d'un groupe électrogène selon l'une des revendications 6 à 10.

14. Système selon la revendication 13, **caractérisé en ce qu'**il comprend en outre un serveur relié auxdits moyens de traitement de données de sorte à stocker au moins en partie des informations relatives à la maintenance dudit groupe électrogène.

## Patentansprüche

1. Überwachungsverfahren der Benutzungszeit eines Stromgenerators (1), wobei das Verfahren geeignet ist, mindestens eine Information zu liefern, die für eine Funktionsdauer des Stromgenerators charakteristisch ist, wobei das Verfahren eine autonome Messeinrichtung (2) einsetzt, die mindestens zwei Sensoren trägt, wobei das Verfahren die folgenden Schritte umfasst, die von der autonomen Einrichtung umgesetzt werden, wenn sie mit einem Gestell des Stromgenerators verbunden ist:
- Messen (10) einer ersten physikalischen Größe mit Hilfe eines ersten der Sensoren;
- Messen (20) einer zweiten physikalischen Größe mit Hilfe eines zweiten der Sensoren;
- Analysieren (30) der ersten und zweiten physikalischen Größen, das eine Information liefert, die für einen Funktionszustand des Stromgenerators repräsentativ ist;
- Bestimmen (40) einer Information, die für eine Gesamtfunktionsdauer des Stromgenerators repräsentativ ist, durch Zusammenfassen der Zeiten, während derer die für einen Funktionszustand repräsentative Information geliefert wird,
- Speichern (50) der für eine Gesamtfunktionsdauer des Stromgenerators repräsentativen Information, und
- Übertragen (60) der für eine Gesamtfunktionsdauer charakteristischen Information von der autonomen Einrichtung zu Datenverarbeitungsmitteln, wenn die autonome Einrichtung an die Datenverarbeitungsmittel angeschlossen ist,
**dadurch gekennzeichnet, dass** das Verfahren ferner einen Schritt der Gewinnung von Lokalisierungsdaten des Stromgenerators umfasst, und dass der Übertragungsschritt (60) einen Unterschritt der Übertragung mindestens eines der Lokalisierungsdaten des Stromgenerators umfasst, um den Stromgenerator zu identifizieren.

2. Überwachungsverfahren der Benutzungszeit nach Anspruch 1, **dadurch gekennzeichnet, dass** der Schritt des Analysierens (30) der ersten und zweiten physikalischen Größen die folgenden Unterschritte umfasst:
- Bearbeiten (301) der ersten gemessenen Größe;
- Vergleichen (303) der ersten gemessenen Größe mit einem ersten vorbestimmten Grenzwert;
- Bearbeiten (302) der zweiten gemessenen Größe;
- Vergleichen (304) der zweiten gemessenen Größe mit einem zweiten vorbestimmten Grenzwert, und
- Bereitstellen (305) der für einen Funktionszustand des Stromgenerators repräsentativen Information in Abhängigkeit von dem Unterschritt des Vergleichens (303) der ersten gemessenen Größe mit einem ersten vorbestimmten Grenzwert und dem Unterschritt des Vergleichens (304) der zweiten gemessenen Größe mit einem zweiten vorbestimmten Grenzwert, wenn die erste Größe und die zweite Größe jeweils größer als der erste bzw. zweite Grenzwert sind.

3. Überwachungsverfahren der Benutzungszeit nach einem der Ansprüche 1 oder 2, **dadurch gekennzeichnet, dass** die erste physikalische Größe für die Funktion eines Motors des Stromgenerators repräsentativ ist, und dass die zweite physikalische Größe für die Funktion eines Wechselstromgenerators des Stromgenerators repräsentativ ist.

4. Überwachungsverfahren der Benutzungszeit nach einem der Ansprüche 1 oder 2, **dadurch gekennzeichnet, dass** es einen vorherigen Schritt des Zusammenschlusses der autonomen Einrichtung mit den Datenverarbeitungsmitteln umfasst.

5. Autonome Einrichtung, **dadurch gekennzeichnet, dass** sie für den Einsatz eines Verfahrens nach einem der Ansprüche 1 bis 4 geeignet ist.

6. Überwachungsverfahren der Wartungszeit eines Stromgenerators in einer kommunizierenden Einrichtung oder einem Server, **dadurch gekennzeichnet, dass** es die folgenden Schritte umfasst:
- Erhalten einer Information, die für eine Gesamtfunktionsdauer charakteristisch ist, durch eine autonome Einrichtung nach Anspruch 5, wobei die Information von der Einrichtung unter Einsatz eines Verfahrens nach einem der Ansprüche 1 bis 4 erhalten wird;
- Verarbeiten (70) der für die Gesamtfunktionsdauer charakteristischen Information, die mindestens eine Information zur Wartung des Stromgenerators in Abhängigkeit von der Funktionsdauer dieses letztgenannten liefert.

7. Überwachungsverfahren der Wartung eines Stromgenerators nach Anspruch 6, **dadurch gekennzeichnet, dass** die mindestens eine Information, die sich auf die Wartung bezieht, folgender Gruppe angehört, umfassend:
- eine Gesamtstundenanzahl der Benutzung des Stromgenerators;
- eine Stundenanzahl der durchgehenden Benutzung des Stromgenerators;
- ein Datum der Erstbenutzung des Stromgenerators;
- ein Datum der Letztbenutzung des Stromgenerators;
- eine Autonomie des Stromgenerators;
- eine Startnotwendigkeit des Stromgenerators;
- eine Stoppnotwendigkeit des Stromgenerators;
- einen Benutzungshinweis des Stromgenerators, oder
- den Wartungsbedarf des Stromgenerators.

8. Überwachungsverfahren der Wartung eines Stromgenerators nach einem der Ansprüche 6 oder 7, **dadurch gekennzeichnet, dass** es ferner einen Schritt der Übertragung (80) mindestens eines Wartungsdatums von den Verarbeitungsmitteln zu der autonomen Einrichtung umfasst.

9. Überwachungsverfahren der Wartung eines Stromgenerators nach Anspruch 8, **dadurch gekennzeichnet, dass** das mindestens eine von den Verarbeitungsmitteln zu der autonomen Einrichtung übertragene Wartungsdatum folgender Gruppe angehört, umfassend:
- eine Aktualisierung eines Wartungsheftes des Stromgenerators;
- ein Datum einer durchgeführten Wartung;
- eine Seriennummer;
- einen einzuhaltenden Wartungsplan;
- ein Benutzerdatum;
- eine Steuerung einer Reinitialisierung der für eine Gesamtfunktionsdauer repräsentativen Information.

10. Überwachungsverfahren der Wartung eines Stromgenerators nach einem der Ansprüche 9 oder 10, **dadurch gekennzeichnet, dass** die Verarbeitungsmittel ein externes Terminal umfassen, und dass das Verfahren mindestens einen Schritt unter folgenden umfasst:
- einen Schritt des Anzeigens (90) mindestens eines Datums unter dem mindestens einen Wartungsdatum, der Systeminformation des Stromgenerators, der mindestens einen für eine Gesamtfunktionsdauer charakteristischen Information, und
- einen Schritt des Empfangens (100) von Instruktionen eines Benutzers, der mit dem externen Terminal interagiert.

11. Computerprogrammprodukt, das von einem Kommunikationsnetz heruntergeladen und/oder auf einem von einem Mikroprozessor lesbaren Träger gespeichert und/oder von einem Mikroprozessor ausgeführt werden kann, **dadurch gekennzeichnet, dass** es Programmcodebefehle für die Ausführung eines Wartungsverfahrens eines Stromgenerators nach einem der Ansprüche 6 bis 10 umfasst, wenn es von einem Computer ausgeführt wird.

12. Speichermedium, das von einem Computer lesbar und nicht transitorisch ist, das ein Computerprogramm speichert, umfassend einen Satz von von einem Computer oder einem Prozessor ausführbaren Befehlen, um das Verfahren nach einem der Ansprüche 6 bis 10 umzusetzen.

13. System, umfassend:
- einen Stromgenerator (1);
- eine autonome Einrichtung (2) zur Überwachung der Benutzungszeit eines Stromgenerators, die an dem Stromgenerator befestigt ist, nach Anspruch 5, und
- Datenverarbeitungsmittel (3), die geeignet sind, ein Überwachungsverfahren der Wartung eines Stromgenerators nach einem der Ansprüche 6 bis 10 umzusetzen.

14. System nach Anspruch 13, **dadurch gekennzeichnet, dass** es ferner einen Server umfasst, der mit den Datenverarbeitungsmitteln verbunden ist, um zumindest teilweise Informationen zur Wartung des Stromgenerators zu speichern.

## Claims

1. Method for monitoring the time of use of a generator set (1), said method
being able to provide at least information characteristic of an operating time of said generator set, said method using an autonomous measuring device (2) carrying at least two sensors, said method
comprising the following steps, implemented by said autonomous device, when it is attached to a frame of said generator set:
- measuring (10) a first physical quantity, using a first of said sensors;
- measuring (20) a second physical quantity, using a second of said sensors;
- analysing (30) said first and second physical quantities, delivering information representing an operating state of said generator set;
- determining (40) information representing an overall operating time of said generator set, by cumulative time during which said information representing an operating state is delivered,
- storing (50) said information representing an overall operating time of said generator set, and
- transmitting (60) said information characteristic of an overall operating time, from said autonomous device to data processing means, when said autonomous device is connected to said data processing means,
**characterised in that** said method furthermore comprises a step of obtaining location data of said generator set and **in that** said transmission step (60) comprises a sub-step of transmitting at least one of said location data of said generator set, so as to identify said generator set.

2. Method for monitoring the time of use according to claim 1, **characterised in that** the step (30) of analysing said first and second physical quantities comprises the following sub-steps:
- processing (301) the first measured quantity;
- comparing (303) the first measured quantity with respect to a first predetermined value threshold;
- processing (302) the second measured quantity;
- comparing (304) the second measured quantity with respect to a second predetermined value threshold, and
- delivering (305) said information representing an operating state of said generator set, according to said sub-step (303) of comparing the first measured quantity with respect to a first predetermined value threshold and said sub-step (304) of comparing the second measured quantity with respect to a second predetermined value threshold, if said first quantity and said second quantity are respectively greater than said first and second thresholds.

3. Method for monitoring the time of use according to one of claims 1 or 2, **characterised in that** said first physical quantity represents the operation of a motor of said generator set, and **in that** said second physical quantity represents the operation of an alternator of said generator set.

4. Method for monitoring the time of use according to either one of claims 1 or 2, **characterised in that** it comprises a preliminary step of pairing said autonomous device with said data processing means.

5. Autonomous device **characterised in that** it is adapted to implement a method according to one of claims 1 to 4.

6. Method for monitoring the maintenance of a generator set, in a communicating device or a server, **characterised in that** it comprises the following steps:
- receiving information characteristic of an overall operating time by an autonomous device according to claim 5, said information being obtained by said device with the implementation of a method according to one of claims 1 to 4;
- processing (70) said information characteristic of an overall operating time, delivering at least one piece of information relating to the maintenance of said generator set, according to the operating time thereof.

7. Method for monitoring the maintenance of a generator set according to claim 6, **characterised in that** said at least one piece of information relating to maintenance belongs to the group comprising:
- a total number of hours of use of the generator set;
- a continuous number of hours of use of the generator set;
- a date of first use of the generator set;
- a date of last use of the generator set;
- autonomy of the generator set;
- a need to start the generator set;
- a need to stop the generator set;
- advice on the use of the generator set, or
- the need to carry out maintenance on said generator set.

8. Method for monitoring the maintenance of a generator set according to one of claims 6 or 7, **characterised in that** it furthermore comprises a step of transmitting (80) at least one item of maintenance data from the processing means to said autonomous device.

9. Method for monitoring the maintenance of a generator set according to claim 8, **characterised in that** said at least one item of maintenance data transmitted from said processing means to said autonomous device belongs to the group comprising:
- an update of a maintenance logbook for the generator set;
- a date of maintenance carried out;
- a serial number;
- a maintenance plan to be followed;
- user data;
- a command to reset said information representing an overall operating time.

10. Method for monitoring the maintenance of a generator set according to one of claims 9 or 10, **characterised in that** said processing means comprise an external terminal, and **in that** said method comprises at least one step from:
- a step (90) of displaying at least one piece of data among said at least one piece of maintenance data, said system information on said generator set, said at least one piece of information characteristic of an overall operating time, and
- a step of receiving instructions (100) from a user interacting with said external terminal.

11. Computer program which can be downloaded from a communications network and/or stored on a microprocessor-readable medium and/or executed by a microprocessor, **characterised in that** it comprises program code instructions for executing a method for maintaining a generator set according to one of claims 6 to 10, when executed on a computer.

12. Computer-readable, non-transient storage medium, storing a computer program comprising a set of instructions executable by a computer or a processor to implement the method according to one of claims 6 to 10.

13. System comprising:
- a generator set (1);
- an autonomous device (2) for monitoring the time of use of a generator set, attached to said generator set, according to claim 5, and
- data processing means (3), capable of implementing a method for monitoring the maintenance of a generator set according to one of claims 6 to 10.

14. System according to claim 13, **characterised in that** it furthermore comprises a server connected to said data processing means so as to at least partly store information relating to the maintenance of said generator set.
